## Europäisches Patentamt

## European Patent Office

## Office européen des brevets

(11) Publication number: **0 104 954**
**B1**

# EUROPEAN PATENT SPECIFICATION

(45) Date of publication of patent specification: 30.01.91

(51) Int. Cl.⁵: **G 03 F 7/09**

(21) Application number: 83305839.9

(22) Date of filing: 28.09.83

(54) Multilayer dry-film photoresist.

(30) Priority: 29.09.82 US 428466
29.09.82 US 428475

(43) Date of publication of application:
04.04.84 Bulletin 84/14

(45) Publication of the grant of the patent:
30.01.91 Bulletin 91/05

(84) Designated Contracting States:
DE FR GB IT

(56) References cited:
US-A-3 649 283

I. SKEIST: "Handbook of Adhesives", 2nd
edition, 1982, page 533, chapter 32, "Acrylic
adhesives and sealants", van Nostrand Reinhold
Co., New York, US

(73) Proprietor: MINNESOTA MINING AND
MANUFACTURING COMPANY
3M Center, P.O. Box 33427
St. Paul, Minnesota 55133-3427 (US)

(72) Inventor: Kausch, William L. Minnesota Mining
and Man. Co.
2501 Hudson Road P.O. Box 33427
St. Paul Minnesota 55133 (US)
Inventor: Vikesland, John P. Minnesota Mining
and Man. Co.
2501 Hudson Road P.O. Box 33427
St. Paul Minnesota 55133 (US)
Inventor: Koelsch, Peter M. Minnesota Mining
and Man. Co.
2501 Hudson Road P.O. Box 33427
St. Paul Minnesota 55133 (US)

(74) Representative: Bowman, Paul Alan et al
LLOYD WISE, TREGEAR & CO. Norman House
105-109 Strand
London WC2R OAE (GB)

Courier Press, Leamington Spa, England.

## Description

The present invention relates to laminable dry-film, positive-acting or negative-acting photoresist. Such photoresists are useful for processes in which substrates are to be etched or are to have material deposited on the surface of the substrate in an imagewise fashion.

Initially, resists were applied to substrates in liquid form. The resist was imagewise subjected to radiation to form relatively soluble and relatively insoluble areas. Upon treatment with an appropriate developer solution, the relatively soluble areas were removed and a physical mask in the desired image pattern was left on the surface of the substrate. The exposed area of the substrate would then be treated by either deposition of material onto the exposed areas (e.g., metal deposition by vapour coating or electrolytic processes) or etching of the surface of the substrate in the area exposed through the mask.

U.S. Patent No. 4,193,797 discloses the use of single layer laminable films of positive-acting dry-film photoresist compositions for use in photoresist processes.

Improved dry-film positive-acting photoresist compositions are disclosed in U.S. Patent No. 4,247,616. This composition provides good light sensitivity, stability, and excellent resist characteristics.

U.S. Patent No. 4,349,620 discloses a multi-layer photosensitive film resist (positive- or negative-acting) having a plurality of layers with differing adhesive properties. In particular a carrier layer having a first photoresistive resist composition thereon and then a second photoresist with different adhesive properties on the first photosensitive composition is disclosed.

Other developments in the art have lead to the use of two layer or multilayer laminable or coatings of photoresist materials in order to provide the sensitometric or physical properties of the dry-film resist. U.K. Patent No. 1,493,833 shows the use of a photoresist comprising a carrier layer, a photosensitive layer (including positive-acting photosensitive layers) and a non-photosensitive layer which is soluble in aqueous or organic solvents. A host of natural and synthetic polymers are disclosed for these non-photosensitive layers. U.S. Patent No. 2,204,009 discloses the use of a resist having two photosensitive layers of different reactivities adjacent each other on top of the substrate to be treated. U.S. Patent No. 4,217,407 discloses the use of multiple layer resist material which comprises an o-quinone diazide containing layer in combination with at least one other layer which is permeable, swellable or soluble by alkaline envelopers. A brief list of non-photosensitive compositions is provided.

U.S. Patent No. 3,469,982 discloses a laminate comprising a layer of light-sensitive photoresist, a permeable backing layer, and an intermediate layer displaced between the light-sensitive photoresist layer and the backing layer, the intermediate layer being soluble in water or developer for the light-exposed photoresist of the laminate. The photoresist layer is adhered to the backing layer through the intermediate layer. In use, the laminate, with the photoresist layer face downward is adhered to a base material, generally by provision of an adhesive layer coated over the photoresist layer, and the composite so formed is washed with a solvent for the intermediate layer. The solvent permeates and undercuts the backing layer and solvates the intermediate layer. This breaks the bond between the resist and backing layers thereby permitting facile removal of the backing layer leaving behind a smooth, uniform layer of resist on the base material. Suitable adhesives are heat-sensitive, pressure-sensitive film forming materials and preferably contain up to 10 percent of the photoresist material. Example 1 discloses the use of an adhesive comprising a cross-linking copolymer of acrylic or methacrylic acid, an epoxy-Nordak thermosetting copolymer and 40 percent of an o-quinone diazide photosensitizer.

It has now been found that the precise degree of undercutting during development of an image formed on a photoresist medium laminated to a substrate by an adhesive layer may be controlled by using an adhesive which is crosslinked.

Therefore according to one aspect of the invention there is provided a dry film, laminable photoresist comprising a carrier bearing a photoresist layer which becomes more soluble or less soluble in an aqueous alkaline solution or organic solvent after exposure to actinic radiation and adjacent and adhered to a surface of the photoresist layer, an adhesive layer comprising organic polymer which is soluble in an aqueous alkaline solution or an organic solvent, the adhesive layer having a surface which is laminable to a receptor layer by heat and pressure in which the adhesive layer is both non-photosensitive and crosslinked.

The present laminable dry-film photoresist article comprises at least two functional layers and a strippable carrier layer which may possess a release layer. One functional layer is a positive-acting or negative-acting dry-film photoresist composition and the second functional layer is a laminable crosslinked adhesive layer.

Dry-film positive-acting photoresist compositions are well described in the art. A polymeric binder (either thermoplastic or crosslinked) usually carries within it or pendant from the polymer itself a light-sensitive material or moiety, the solubility of which in selected solvents increases when exposed to radiation. The photosoluble moiety may also be a part of the polymer backbone. The most preferred class of positive-acting photosensitizers are those with o-quinone diazide groups. These materials are generally referred to in the art as o-quinone diazides. These compounds are well disclosed in the literature as, for example, in U.S. Patent Nos. 4,349,620; 4,345,020; 4,346,163; 4,193,797; 4,217,407; 4,247,616; 4,211,834; 4,007,047; 3,666,473; 3,201,239 and 4,180,604. These positive-acting photosensitizers are generally used in amounts of from 5 to 80% by weight of the resist layer, and preferably from 10 to 50% of the layer. These patents also describe the various different binders that can be used with the positive-acting o-quinone diazides. The preferred material tends to be phenol formaldehyde resin (either novolaks or resoles alone or in combination with crosslinked epoxies as disclosed in U.S. Patent No. 4,247,616), but a wide variety of various binders are used in the art. These binders include acrylic resins (e.g., alkyl methacrylate, ethylacrylate, copolymers and the like) polymeric polyols (e.g. polyvinyl alcohol, and hydroxy substituted addition polyesters such as polyacrylate and polymethacrylate polyesters), hydroxy substituted copolymers (such as poly[methylmethacrylate/hydroxy methacrylate]), natural colloids (for example, gelatin and shellac), polyvinyl hydrogenphthalate, ethylene oxide polymers and copolymers, polyacrylamides, polyethylenically unsaturated materials (such as polystyrene and its copolymers), polyamides, polyesters, and the other various polymeric materials both natural and synthetic, thermoplastic and crosslinked as known in the art. The only requirement is that these materials have at least some reasonable solubility in aqueous alkaline or organic developer solutions. The thickness of the photosensitive layer may generally be between 0.05 and 2.0 mils, preferably between 0.10 and 0.50 mils, most preferably at least 0.1 and less than 0.3 mils.

Dry-film negative-acting photoresist compositions are well described in the art. A polymeric binder usually carries within it a light-sensitive material, the solubility of which in selected solvents decreases when exposed to radiation.

The photoresist composition may be any negative-acting photoresistive resist material known in the art. Negative acting photosensitive resist systems ordinarily comprise a polymerizable composition which polymerizes in an imagewise fashion when irradiated, such as by exposure to light. These compositions are well reported in the literature and are commercially available. These compositions ordinarly comprise ethylenically or polyethylenically unsaturated polymerizable materials in combination with photosensitive epoxy systems with photoinitiated cationic polymerization catalysts are also known in the art. Preferably ethylenically unsaturated photopolymerizable systems are used, such as acrylate, methacrylate, acrylamide and allyl systems. Acrylic and methacrylic polymerizable systems of oligomers, trimers, dimers or monomers in combination with free radical photoinitiators are most preferred according to the practice of the present invention. U.S. Patent Nos. 3,639,185; 4,349,620; 4,008,084; 4,138,262; 4,139,391; 4,158,079; and 3,469,982, disclose photosensitive compositions generally useful in the practice of the present invention. Non-polymerizable binders, dyes, pigments, antioxidants, filler, surfactants, antistatic agents, lubricants and other well known adjuvants may be present within the photoresist layer. Useful binders, for example, include acrylic resins (e.g., alkyl methacrylate, ethylacrylate, copolymers and the like) polymeric polyols (e.g., polyvinyl alcohol, and hydroxy substituted addition polyesters such as polyacrylate and polymethacrylate polyesters), hydroxy substituted copolymers (such as poly[methyl methacrylate/hydroxy methylacrylate]), natural colloids (for example, gelatin and shellac), polyvinyl hydrogenphthalate, ethylene oxide polymers and copolymers, polyacrylamides, polyethylenically unsaturated materials (such as polystyrene and its copolymers), polyamides, polyesters, and the other various polymeric materials both natural and synthetic, thermoplastic and crosslinked as known in the art. The only requirement is that these materials have at least some reasonable solubility in aqueous alkaline or organic developer solutions. The thickness of the photosensitive layer may generally be between 0.05 and 2.0 mils, preferably between 0.10 and 0.50 mils, most preferably at least 0.1 and less than 0.3 mils.

The thermoplastic adhesive layer is essential to successful commercial practice of dry-film, positive-acting photoresist technology. Monolayer constructions have to date been unable to meet even existing commercial needs for (1) resistance to crazing of the film during storage (because of the brittle nature of the film), (2) photosensitivity, the speed of the film being too slow for commercial processes, and (3) thermal dimensional stability of the film during plating and etching processes. The use of the distinct, non-photosensitive adhesive layer to make the photoresist article laminable overcomes all three of these problems. It is the presence of the integral adhesive layer between the photoresist layer and the receptor layer which improves these areas of positive-acting, dry-film photoresist technology, while monolayer constructions have not satisfied the needs of the technology.

The crosslinked laminable layer may be made of any compositions which are soluble in aqueous alkaline or organic solvent solutions and are not sufficiently crosslinked so as to prevent bonding of that layer to a substrate when pressed and heated. Typically, the crosslinked layer should be capable of adhering to at least one substrate of mildly abraded copper, aluminum, tin, or polyester when pressed against such a surface with a force of no more than ten pounds per square inch at a temperature no greater than 150°C for no longer than twenty seconds. These characteristics define the term laminable in the practice of the present invention. The crosslinkable resin (that is, without the external application of chemical crosslinking materials) is crosslinked to any degree consistent with its also being laminable. This can be achieved by various means known to the ordinarily skilled artisan such as inclusion of crosslinking agents, partial crosslinking of the original composition which may be further crosslinked by heating, etc.

The necessity for crosslinking in the laminable layer derives from the fact that the many various applications of the dry-film photoresist article will require different properties in the various applications. This is why the crosslinkable ability of the layer, which is controllable by the degree of crosslinking stimulation given that layer, is the preferred embodiment of the present invention. Crosslinking is an improvement over the general use of thermoplastic materials as the laminable layer in the prior art because of the improved control of solubility which can be given those layers.

The control of solubility in thermoplastic laminable layers quickly reaches a point of diminishing returns. Particularly when organic solvents are being used as a developer, increasing the molecular weight of thermoplastic polymers used in the laminable layer becomes more difficult and less productive in reducing the natural solubility of that layer in developer solvents. Doubling the molecular weight of a thermoplastic polymer from 500,000 to a million, for example, does not provide for facile control of solubility properties and does not easily produce a polymer with consistent properties because of the significant distribution of molecular weights within the polymerized material. Controlled crosslinking, on the other hand, tends to provide a more consistent composition with more accurately controlled solubility properties. This is particularly true with respect to thermal dimensional stability in the laminated resist which is extremely important in many fine detail processes where elevated temperatures are used, such as in plating processes.

Any polymeric material which can be crosslinked and in its incompletely crosslinked stage (i.e., at least partially crosslinked), is soluble in aqueous alkaline solutions (e.g., NaOH at pH 13.0) or organic solvents is useful in the practice of the present invention. By crosslinked, it is understood that the polymeric composition has at least some three dimensional structure to it and is at least ten percent (preferably at least 15 or 20 percent and more preferably 25 or at least 50 percent) less soluble in the selected developer solution than the polymeric composition without the crosslinking therein. Amongst the various classes of materials that can be used for the laminable layer are phenol formaldehyde resins (including novolaks), epoxy resins, acrylic resins (and copolymers), polyesters, polyamides, and the like. Each of these materials is well known in the art to be crosslinkable, and the skilled artisan is well aware of the various crosslinking agents which can be used for the various polymeric materials. These, for example, include diisocyanates and epoxies, diacid chlorides, dianhydrides, diacids, polyisocyanates, polyepoxides, polyacids, aziridines, azolactones, dihalides, polyhalides, and the like. No crosslinked layer should be in combination with the photosensitive resist layer prior to lamination if it is so crosslinked that it is neither laminable nor soluble in both aqueous alkaline solutions and organic solvent solutions. This control is well understood by those of ordinary skill in the art and can be determined for any crosslinkable material and any particular crosslinking agent by routine experimentation. Mixtures of these crosslinkable materials together or in combination with thermoplastic materials may be readily practiced by one of ordinary skill in the art. For example, the composition of U.S. Patent No. 4,247,616 may be used as the laminable layer as well as the binding composition for the positive-acting photosensitizers. The preferred compositions of the present invention for the laminable layer comprise phenol formaldehyde resins blended with acrylic resins and particularly resole resins and acrylic terpolymers. A typical developer solution for determining relative solubility for crosslinked materials, as defined above, would be aqueous sodium hydroxide solutions of pH 13.0 to 13.5.

The photosensitive and laminable layers may vary in thickness depending on their particular needs. Generally the various layers will range from 0.05 to 50 microns, preferably from 0.05 to 5 microns, and most preferably from 0.08 to 3 microns for the photosensitive resist layer. The other, non-sensitive, laminable crosslinked or crosslinkable layer may be of the same, smaller, or larger thickness, but should remain within the broad limits given for the photosensitive resist layer.

Various other ingredients may be included in these layers as is well understood in the art. Surfactants, spectral sensitizers, dyes, fillers, lubricants, coating aids, spectral absorbers (such as ultraviolet radiation absorbers) and the like may be used as is understood in the art. These and other aspects of the present invention will be disclosed in the following examples.

Example 1

A positive-acting photosensitive coating solution was prepared by mixing the following:

| | |
|---|---|
| Acetone | 40 g |
| Resinox, a novolak phenolic (phenol-formaldehyde) resin | 60 g |
| Acryloid AT-70, a styrene, ethyl-acrylate acrylic acid terpolymer (50% solids resin in a xylene and Glycol monomethyl ether acetate 50/50 solvent) | 4 g |
| DMP-30, 2,4,6-tris(dimethylamino-methyl)phenol amine catalyst | 0.2 g |
| DDI-1410, a 36 carbon atom aliphatic diisocyanate | 1.3 g |
| Phenyl isocyanate | 2.5 g |

After a reaction time of two hours, this solution was mixed with the following additional materials:

| DER 732, propylene glycol di(2,3-glycidylpropyl)ether | 3.2 g |
|---|---|
| Diaminodiphenylsulfone | 1.3 g |
| Phthalic anhydride | 0.4 g |
| 2,4 dihydroxybenzophenone bis-[naphthoquinone-(1,2)-diazide-(2)-5-sulfonate] the photosensitizer | 7.4 g |

This solution was then coated onto a polyester web bearing a release layer of Gantrez S-95, an acidified copolymer of maleic anhydride and methyl vinyl ether. The drying temperature was 100°C for 3 minutes. The dry thickness of the photosensitive layer was 0.2—0.3 mil. Other photosensitive coatings as described in U.S. Patent No. 4,247,616 may be used.

The non-photosensitive solution was coated onto the dried photosensitive layer to a thickness of 0.25—0.35 mil after drying at 100°C for 3 minutes. The preferred non-photosensitive coating solution is:

| 30 g | Acetone |
|---|---|
| 5.4 g | BKR 2620, a resole type phenol formaldehyde resin |
| 0.05 g | Triethylenediamine |
| 0.2 g | DDI-1410, a 36 carbon atom aliphatic diisocyanate |
| 2.0 g | Carboset 525, ethyl acrylate, methyl acrylate, acrylic acid terpolymer |

The coated dry-film was laminated at a rate of 3 ft/minute to a copper foil using a heated-roll laminator set at 110°C. The laminated resist was then exposed through a photomask and developed with an approximately 1.0% solution of sodium hydroxide. The resulting image quality was excellent down to a linewidth resolution of 0.5 mil. This composition is thermally stable, giving negligible movement of the edge profile of the resist at bath temperature up to 170°F (which is higher than the maximum temperature of commonly employed electroplating solutions). Chemical resistance to $FeCl_3$ etchant at 150°F was outstanding.

A non-crosslinked composition identical to that used as the non-photosensitive composition of Example 1 was prepared, except that the triethylenediamine (crosslinking catalyst) and the diisocyanate (DDI-1410 crosslinking agent) were excluded. That composition was coated onto the photosensitive layer and dried in the same manner as in Example 1. The bilayer was then laminated, exposed and developed as in that example. Microscopic examination of the developed photoresist showed significant image undercutting and loss of resolution in the non-crosslinked, bilayer image.

Examples 2—4

In addition to the above example, the following non-photosensitive compositions have also been successfully employed.

| A. | 38.1 g | Acetone |
|---|---|---|
| | 5.1 g | BKR 2620 |
| | 3.1 g | Carboset 525 |
| | 0.13 g | Gantrez AN119, (maleic anhydride, methyl vinyl ether copolymer) |

| B. | 40 g | Acetone |
|---|---|---|
| | 0.05 g | Triethylene diamine |
| | 5.4 g | BKR 2620 |
| | 0.1 g | Phenylisocyanate |
| | 2.0 g | Carboset 525 |

| C. | 50 g | Toluene |
|---|---|---|
| | 10 g | Acryloid AT-70 |
| | 1.4 g | DER-732 |
| | 0.3 g | Methanesulfonic acid |

Compositions B and C are crosslinkable compositions. When initially laminated, the compositions were capable of being undercut by development. By heating the laminated composition, the crosslinking reaction was initiated and various degrees of crosslinking could be generated. In this manner the precise degree of undercutting of the mask or image could be controlled offering a highly desirable degree of latitude in processing. Heating of composition B at 250°F for fifteen minutes after lamination produced an adhesive layer that was barely undercut by the developer (aqueous alkaline solution at pH 13+).

Example 5

Practice of the invention is illustrated in the following example. The photosensitive layer was coated onto a polyester film bearing a release coating of Gantrez S-95 an acidified copolymer of a maleic anhydride and methyl vinyl ether. The drying temperature was 75°C for 1.5 minutes. The dry thickness of the photosensitive layer was 0.15 mil. The photosensitive coating was made from a 11% solids solution in a solvent of (50%) ethylene dichloride and (50%) methyl ethyl ketone of the following composition:

30%—pentaerythritoltetramethacrylate
33%—SMA 17362, a partially esterified styrene-maleic anhydride copolymer
20%—the reaction product of G-cure 867, a hydroxy-functional acrylic copolymer, and isocyanato ethyl methacrylate
3%—U-34, an acrylate functional urethane oligomer containing acid groups made according to U.S. 4,228,232 (Preparation V)
6%—1:2 mixture of Michler's Ketone and diphenyliodonium hexafluorophosphate
5%—of an s-triazine free radical photoinitiator
3%—pigment and inert binder resin

The photosensitive coating was then overcoated with the nonphotosensitive coating using a 20% solids solution in acetone of the reacted composition:

69%—BKR 2620, a resole type phenol-formaldehyde resin
0.6%—Triethylenediamine
1.6%—a 36 carbon atom aliphatic diisocyanate
2.4%—Phenylisocyanate
26%—Carboset 525, an ethyl acrylate, methyl acrylate, and acrylic acid terpolymer
0.4%—Rhodamine B—a dye

The nonphotosensitive coating was dried at 100°C for 2 minutes and had a dry thickness of about 0.3 mil. The dry-film was laminated at 3 ft/min to copper coil using a heated-roll laminator set at 110°C. The laminated resist was exposed through a photomask and developed with an approximately 1.0% solution of sodium hydroxide. The unexposed areas were removed and the resulting image was very good.

Examples 6—8

In addition to the above Example 5, the following non-photosensitive compositions have also been successfully employed as the laminable polymer.

A.  38.1 g  Acetone
    5.1 g   BKR 2620
    3.1 g   Carboset 525
    0.13 g  Gantrez AN119, (maleic anhydride, methyl vinyl ether copolymer)

B.  40 g    Acetone
    0.05 g  Triethylene diamine
    5.4 g   BKR 2620
    0.1 g   Phenylisocyanate
    2.0 g   Carboset 525

C.  50 g    Toluene
    10 g    Acryloid AT-70
    1.4 g   DER-732
    0.3 g   Methanesulfonic acid

Compositions B and C are crosslinkable compositions. When initially laminated, the compositions were capable of being undercut by development. By heating the laminated composition, the crosslinking reaction was initiated and various degrees of crosslinking could be generated. In this manner, the precise degree of undercutting of the mask or image could be controlled offering a highly desirable degree of latitude in processing. Heating of composition B at 250°F for fifteen minutes after lamination produced an adhesive layer that was barely undercut by the developer (aqueous alkaline solution at pH 13+).

**Claims**

1. A dry film, laminable photoresist comprising a carrier bearing a photoresist layer which becomes more soluble or less soluble in an aqueous alkaline solution or organic solvent after exposure to actinic radiation and adjacent and adhered to a surface of the photoresist layer, a non-photosensitive adhesive layer comprising organic polymer which is soluble in an aqueous alkaline solution or an organic solvent, the adhesive layer having a surface which is laminable to a receptor layer by heat and pressure

EP 0 104 954 B1

characterised in that the organic polymer of adhesive layer is crosslinked to a degree such that it is at least 10% less soluble in said aqueous alkaline solution or organic solvent than it would be without the crosslinking.

2. A photoresist as claimed in Claim 1 characterised in that the photoresist is a positive-acting photoresist and comprises an o-quinone diazide in an organic polymeric binder.

3. A photoresist as claimed in Claim 2 characterised in that the organic polymeric binder comprises a phenol formaldehyde resin.

4. A photoresist as claimed in Claim 1 characterised in that the photoresist layer is a negative-acting photoresist and comprises an ethylenically unsaturated material and a photosensitive free radical generator.

5. A photoresist as claimed in preceding claim characterised in that the organic polymeric of the adhesive layer is crosslinked by the application heat thereto.

6. A photoresist as claimed in any preceding claim characterised in that the organic polymeric of the adhesive layer comprises an acrylic polymer.

7. A photoresist as claimed in Claim 6 characterised in that the organic polymer of the adhesive layer comprises a phenol formaldehyde resin and an acrylic polymer.

8. A photoresist as claimed in Claim 6 characterised in that the adhesive layer comprises (1) an acrylic copolymer or terpolymer and (2) a phenol formaldehyde resin crosslinked with a polyisocyanate.

9. A photoresist as claimed in any preceding claim characterised in that there is a release layer between the carrier and the photoresist layer.

10. A photoresist as claimed in any preceding claim characterised in that the organic polymer of the adhesive layer is crosslinked to such a degree that it is at least 50% less soluble in said aqueous alkaline solution or organic solvent than it would be without the crosslinking.

**Patentansprüche**

1. Laminierbarer Trockenphotolack, umfassend einen Träger, der eine Photolackschicht trägt, welche in einer wäßrigen alkalischen Lösung oder einem organischen Lösungsmittel nach der Einwirkung von photochemisch wirksamer Strahlung mehr oder weniger löslich wird und anliegend und an einer Oberfläche des Photolacks anhaftend, eine nicht-lichtempfindliche Kleberschicht, die ein organisches Polymer umfaßt, welches in wäßriger alkalischer Lösung oder einem organischen Lösungsmittel löslich ist, wobei die Kleberschicht eine Oberfläche besitzt, die unter Hitzeeinwirkung und Druck auf eine Aufnahmeschicht laminierbar ist, dadurch gekennzeichnet, daß das organische Polymer der Kleberschicht bis zu einem solchen Grad vernetzt ist, daß es in wäßriger alkalischer Lösung oder einem organischen Lösungsmittel mindestens 10% weniger löslich ist, als es ohne Vernetzung sein würde.

2. Photolack nach Anspruch 1, dadurch gekennzeichnet, daß der Photolack ein positiv arbeitender Photolack ist und ein o-Chinondiazid in einem organischen polymeren Bindemittel umfaßt.

3. Photolack nach Anspruch 2, dadurch gekennzeichnet, daß das organische polymere Bindemittel ein Phenol-Formaldehyde-Harz umfaßt.

4. Photolack nach Anspruch 1, dadurch gekennzeichnet, daß die Photolackschicht ein negativ arbeitender Photolack ist und einen ethylenisch ungesättigten Stoff und einen lichtempfindlichen Erzeuger von freien Radikalen umfaßt.

5. Photolack nach einem vorangehenden Anspruch, dadurch gekennzeichnet, daß das organische Polymer der Kleberschicht durch Hitzeeinwirkung vernetzt ist.

6. Photolack nach einem vorangehenden Anspruch, dadurch gekennzeichnet, daß das organische Polymer der Kleberschicht ein Acrylpolymer umfaßt.

7. Photolack nach Anspruch 6, dadurch gekennzeichnet, daß das organische Polymer der Kleberschicht ein Phenol-Formaldehyd-Harz und ein Acrylpolymer umfaßt.

8. Photolack nach Anspruch 6, dadurch gekennzeichnet, daß die Kleberschicht

(1) ein Acryl-Copolymer oder -terpolymer und

(2) ein mit einem Polyisocyanat vernetztes Phenol-Formaldehyd-Harz, umfaßt.

9. Photolack nach einem vorangehenden Anspruch, dadurch gekennzeichnet, daß sich zwischen dem Träger und der Photolackschicht eine Trennschicht befindet.

10. Photolack nach einem vorangegangenen Anspruch, dadurch gekennzeichnet, daß das organische Polymer der Kleberschicht in einem solchen Grade vernetzt ist, daß es in alkalischer wäßriger Lösung oder organischem Lösungsmittel mindestens 50% weniger löslich ist, als es ohne Vernetzung sein würde.

**Revendications**

1. Photo-réserve à sec multicouche, comprenant un support portant une couche de photo-réserve qui devient plus soluble ou moins soluble dans une solution alcaline aqueuse ou un solvant organique après exposition à un rayonnement actinique, et, contiguë à une surface de cette couche de photo-réserve et adhérent sur cette surface, une couche de substance adhésive non-photosensible comprenant un polymère organique qui est soluble dans une solution alcaline aqueuse ou un solvant organique, la couche de substance adhésive présentant une surface qui peut être superposée à une couche réceptrice, de manière à

7

être fixée sur celle-ci, par une application de chaleur et de pression, caractérisée en ce que le polymère organique de la couche de substance adhésive est réticulé à un degré tel qu'il est moins soluble d'au moins 10% dans la solution alcaline aqueuse ou le solvant organique qu'il ne le serait sans la réticulation.

2. Photo-réserve suivant la revendication 1, caractérisée en ce qu'il s'agit d'une photo-réserve à action positive et en ce qu'elle comprend un o-quinone-diazide dans un liant polymère organique.

3. Photo-réserve suivant la revendication 2, caractérisée en ce que le liant polymère organique comprend une résine phénol-formaldéhyde.

4. Photo-réserve suivant la revendication 1, caractérisée en ce que la couche de photo-réserve est une photo-réserve à action négative et en ce qu'elle comprend un composé éthyléniquement insaturé et un générateur de radicaux libres photosensible.

5. Photo-réserve suivant l'une quelconque des revendications précédentes, caractérisée en ce que le polymère organique de la couche de substance adhésive est réticulé par application de chaleur.

6. Photo-réserve suivant l'une quelconque des revendications précédentes, caractérisée en ce que le polymère organique de la couche de substance adhésive comprend un polymère acrylique.

7. Photo-réserve suivant la revendication 6, caractérisée en ce que le polymère organique de la couche de substance adhésive comprend une résine phénol-formaldéhyde et un polymère acrylique.

8. Photo-réserve suivant la revendication 6, caractérisée en ce que la couche de substance adhésive comprend (1) un copolymère, ou terpolymère, acrylique et (2) une résine phénol-formaldéhyde réticulée à l'aide d'un polyisocyanate.

9. Photo-réserve suivant l'une quelconque des revendications précédentes, caractérisée en ce qu'il existe une couche anti-adhésive entre le support et la couche de photo-réserve.

10. Photo-réserve suivant l'une quelconque des revendications précédentes, caractérisée en ce que le polymère organique de la couche de substance adhésive est réticulé à un degré tel qu'il est moins soluble d'au moins 50% dans la solution alcaline aqueuse ou le solvant organique qu'il ne le serait sans la réticulation.